# EUROPÄISCHE PATENTSCHRIFT

(11) **EP 1 051 756 B1**
(45) Veröffentlichungstag und Bekanntmachung des Hinweises auf die Patenterteilung: **31.12.2008**
(21) Anmeldenummer: 99963211.0
(22) Anmeldetag: 04.11.1999
(51) Int. Cl.: H01L 29/78

(54) **MOS-FELDEFFEKTTRANSISTOR MIT HILFSELEKTRODE**
MOS FIELD EFFECT TRANSISTOR WITH AN AUXILIARY ELECTRODE
TRANSISTOR MOS A EFFET DE CHAMP AVEC ELECTRODE AUXILIAIRE

(30) Priorität: 27.11.1998 DE 19854915
(43) Veröffentlichungstag der Anmeldung: 15.11.2000
(73) Patentinhaber: Infineon Technologies AG, 81669 München (DE)
(72) Erfinder: TIHANYI, Jenoe, D-85551 Kirchheim (DE)
(74) Vertreter: Müller - Hoffmann & Partner
(86) Internationale Anmeldenummer: PCT/DE1999/003542
(87) Internationale Veröffentlichungsnummer: WO 2000/033385

(56) Entgegenhaltungen:
- EP-A- 0 915 521
- DE-A- 4 309 764
- DE-A- 19 534 154
- DE-A- 19 604 043
- DE-A- 19 611 045
- US-A- 5 216 275

## Beschreibung

Die vorliegende Erfindung betrifft einen MOS-Feldeffekttransistor mit
- einem eine erste und eine zweite Hauptoberfläche aufweisenden Halbleiterkörper des einen Leitungstyps, in den auf der Seite der ersten Hauptoberfläche wenigstens eine erste Halbleiterzone des anderen, zum einen Leitungstyp entgegengesetzten Leitungstyps eingebettet ist,
- mindestens einer zweiten Halbleiterzone des einen Leitungstyps, die in der ersten Halbleiterzone vorgesehen ist,
- einer Gateelektrode wenigstens im Bereich oberhalb der ersten Halbleiterzone zwischen der zweiten Halbleiterzone und dem Halbleiterkörper,
- einer den Halbleiterkörper auf der zweiten Hauptoberfläche kontaktierenden ersten Elektrode und einer mindestens die zweite Halbleiterzone kontaktierenden zweiten Elektrode und
- wenigstens einer mit einer Isolierschicht versehenen Hilfselektrode, die sich im Halbleiterkörper (1) in der Richtung zwischen der ersten und der zweiten Hauptoberfläche des Halbleiterkörpers erstreckt, wobei
- die Hilfselektrode an die erste Halbleiterzone angrenzt und
- die Isolierschicht die Hilfselektrode vom Halbleiterkörper trennt.

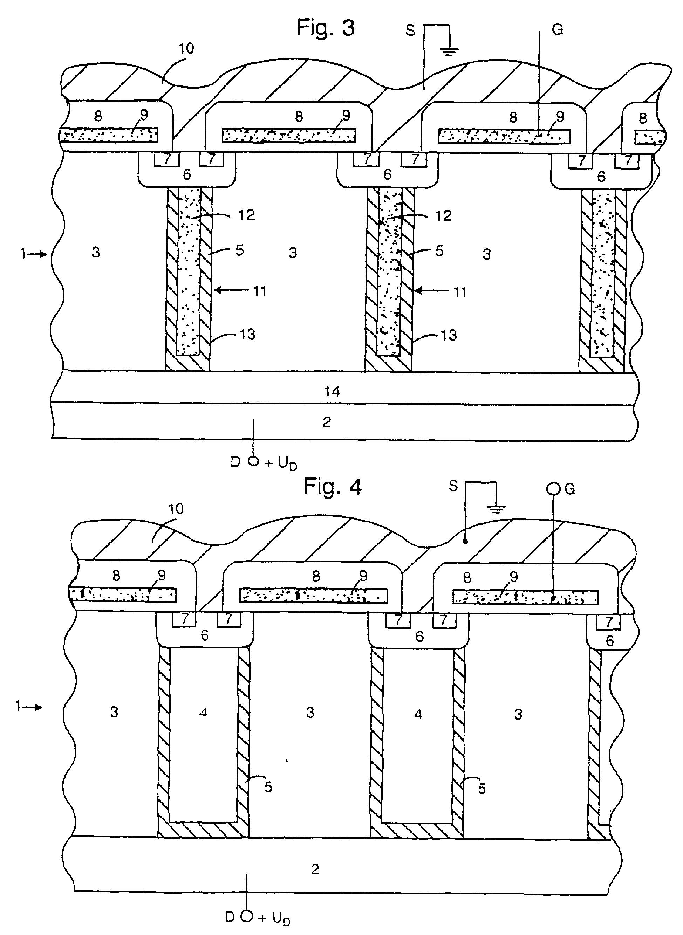

Bekanntlich wird schon seit langem nach Möglichkeiten gesucht, den Einschaltwiderstand Rₒₙ speziell von Leistungs-MOS-Feldeffekttransistoren (FET's) zu reduzieren. So ist beispielsweise in der US 5 216 275 eine Leistungs-Halbleitervorrichtung beschrieben, die grundsätzlich in der eingangs beschriebenen Art aufgebaut ist: die Driftstrecke dieser Halbleitervorrichtung ist mit einer sogenannten "Spannungshalteschicht" ("voltage sustaining layer") versehen, die aus vertikalen, nebeneinanderliegenden p- und n-leitenden Gebieten besteht, welche einander abwechseln und zwischen denen eine Isolierschicht aus Siliziumdioxid vorgesehen ist. Als Beispiel einer derartigen üblichen Halbleitervorrichtung ist in Fig. 4 ein MOSFET gezeigt.

Dieser bekannte MOSFET besteht aus einem Halbleiterkörper 1 mit einer n⁺-leitenden Drain-Kontaktzone 2, einander abwechselnden n-leitenden und p-leitenden Halbleiterzonen 3 bzw. 4, die voneinander durch eine Isolierschicht 5 aus beispielsweise Siliziumdioxid getrennt sind, p-leitenden Halbleiterzonen ("Body"-Zonen) 6 und n-leitenden Halbleiterzonen 7, die in die Zonen 6 eingebettet sind.

Für den Halbleiterkörper 1 wird in üblicher Weise Silizium verwendet, obwohl gegebenenfalls auch andere Materialien eingesetzt werden können. Auch können gegebenenfalls die angegebenen Leitungstypen umgekehrt sein.

Gateelektroden 9 aus dotiertem polykristallinem Silizium sind in eine Isolierschicht 8 aus beispielsweise Siliziumdioxid oder Siliziumnitrid eingebettet und mit einem Anschluß G versehen. Eine Metallschicht 10 aus beispielsweise Aluminium kontaktiert die n-leitenden Zonen 7 und ist mit einem Sourceanschluß S versehen, der geerdet sein kann. An der n⁺-leitenden Halbleiterschicht 2, die mit einem Drainanschluß D versehen ist, liegt eine Drainspannung +U_{D}.

Bei angelegter Spannung +U_{D}, werden die Zonen 3 und 4 gegenseitig an Ladungsträgern ausgeräumt. Ist in diesen Zonen 3, 4, die zwischen den beiden Hauptoberflächen des Halbleiterkörpers 1 säulenförmig verlaufen, die Gesamtmenge der n-Dotierung und der p-Dotierung etwa gleich oder so gering, daß diese Zonen 3, 4 vollständig an Ladungsträgern ausgeräumt sind, bevor ein Durchbruch eintritt, so kann ein solcher MOSFET hohe Spannungen sperren und dennoch einen niedrigen Einschaltwiderstand Rₒₙ aufweisen. Infolge der Isolierschicht 5 zwischen den n-leitenden Zonen 3 und den p-leitenden Zonen 4 dienen hier die p-leitenden Zonen 4, die unterhalb der Zonen 6 angeordnet sind, als geerdete Feldplatten für die n-leitenden Zonen 3, solange diese nicht vollständig an Ladungsträgern ausgeräumt sind.

Ein MOSFET mit der in Fig. 4 gezeigten Struktur ist in seiner Herstellung relativ aufwendig, was insbesondere auf die Bildung der Isolierschichten 5 und der von diesen umgebenen p-leitenden Zonen 4 in einem n-leitenden Halbleiterkörper 1 zurückzuführen ist.

Schliesslich ist aus der DE19611045C1 ein MOSFET bekannt, bei dem aus polykristallinen Silizium bestehende und in einer Isolierschicht eingebettete Feldelektroden eine Bodyzone durchsetzen und direkt an eine Source-Metallisierung angeschlossen sind. Die Feldelektroden und die sie umgebenden Isolierschichten sind dabei in Trenches in einem Halbleiterkörper gelegen, wobei die Trenchwände des Halbleiterkörpers hochdotiert sind.

Es ist Aufgabe der vorliegenden Erfindung, einen MOSFET zu schaffen, der einen ähnlich niedrigen Einschaltwiderstand wie der bestehende MOSFET hat und möglichst kurzschlusssicher ist.

Diese Aufgabe wird bei einem MOSFET der eingangs genannten Art erfindungsgemäß dadurch gelöst, dass die Hilfselektrode aus hochdotiertem polykristallinem Silizium des anderen Leitungstyps besteht, das mit der aus Siliziumdioxid bestehenden Isolierschicht umgeben ist. Die Hilfselektrode liegt direkt unterhalb der ersten Halbleiterzone.

Dabei ist es auch möglich, daß mehrere derartige Hilfselektroden unterhalb jeder ersten Halbleiterzone vorgesehen sind. Diese Hilfselektroden können gegebenenfalls "bleistiftartig" gestaltet sein. Die Hilfselektroden können sich bis zu einer hochdotierten Schicht des einen Leitungstyps im Bereich der zweiten Hauptoberfläche, also bis in die Nähe zu einer Drain-Kontaktzone erstrecken. Es ist aber auch möglich, daß die Hilfselektroden lediglich bis zu einer schwach dotierten Schicht des einen Leitungstyps reichen, die zwischen dem Halbleiterkörper und einer mit der ersten Elektrode kontaktierten stark dotierten Halbleiterschicht des einen Leitungstyps vorgesehen ist.

Die Hilfselektrode selbst besteht aus hochdotiertem polykristallinem Silizium des anderen Leitungstyps, während für die Isolierschicht in bevorzugter Weise Siliziumdioxid verwendet wird.

Die Tiefe der Hilfselektroden kann beispielsweise zwischen 5 und 40 µm liegen, während ihre Breite in der Größenordnung von 1 bis 5 µm sein kann. Die Dicke der Isolierschicht auf dem polykristallinen Silizium der Hilfselektrode kann zwischen 0,1 und 1 µm liegen, wobei diese Dicke in Richtung auf die zweite Hauptoberfläche oder zur Mitte der Hilfselektroden zwischen den beiden Hauptoberflächen hin ansteigen kann.

Der erfindungsgemäße MOSFET ist in folgender Weise herstellbar: in den beispielsweise n-leitenden Halbleiterkörper werden Gräben (Trenche) beispielsweise durch Ätzen eingebracht. Die Wände und Böden dieser Trenche werden mit einer Isolierschicht versehen, was durch Oxidation geschehen kann, so daß bei dem aus Silizium bestehenden Halbleiterkörper als Isolierschicht eine Siliziumdioxidschicht gebildet wird. Sodann werden die Trenche mit n⁺- oder p⁻-leitendem polykristallinem Silizium gefüllt, was keine Probleme aufwirft.

Dabei wird bei einem n-leitenden Halbleiterkörper eine p⁺-Dotierung für das polykristalline Silizium der Hilfselektrode vorgesehen: sollte nämlich in der Isolierschicht ein Loch vorhanden sein, so entsteht nach einer p-Diffusion durch das Loch in dem n-leitenden Halbleiterkörper ein sperrender pn-Übergang. Im Falle einer n⁺-Dotierung für das polykristalline Silizium der Hilfselektrode würde dagegen durch ein solches Loch ein Kurzschluß zum n-leitenden Halbleiterkörper hervorgerufen werden.

Die Hilfselektroden selbst können säulen-, gitter- oder streifenförmig sein oder sonstige Gestaltungen besitzen.

Auch können die n-leitenden Halbleiterzonen um so höher dotiert werden, je näher die Hilfselektroden zueinander stehen. Dabei ist aber zu berücksichtigen, daß bei parallel zueinander verlaufenden Hilfselektroden die seitliche Flächenladung der n-leitenden Halbleiterzonen die dem Doppelten der Durchbruchsladung entsprechende Dotierstoffmenge nicht überschreiten darf.

Die Dotierung im polykristallinen Silizium der Hilfselektroden braucht nicht homogen zu sein. Vielmehr sind hier ohne weiteres Schwankungen in der Dotierungskonzentration zulässig. Auch ist die Tiefe der Hilfselektroden bzw. der Trenche nicht kritisch: diese können bis zu einer hochdotierten Drain-Kontaktzone reichen, brauchen dies aber nicht zu tun.

Anstelle eines beispielsweise n-leitenden Halbleiterkörpers können für diesen auch Schichten mit unterschiedlicher Dotierung vorgesehen werden.

Nachfolgend wird die Erfindung anhand der Zeichnungen näher beschrieben. Es zeigen:
- Fig. 1: einen Schnitt durch einen MOSFET nach einem ersten Ausführungsbeispiel der Erfindung,
- Fig. 2: einen Schnitt durch einen MOSFET nach einem zweiten Ausführungsbeispiel der Erfindung,
- Fig. 3: einen Schnitt durch einen MOSFET nach einem dritten Ausführungsbeispiel der Erfindung, und
- Fig. 4: einen Schnitt durch einen bestehenden MOSFET.

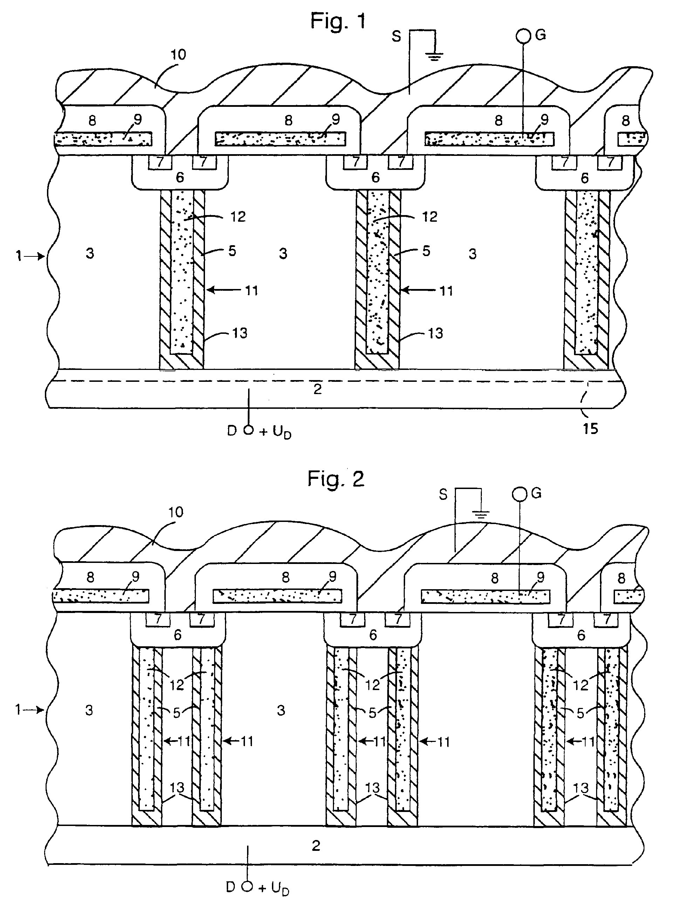

Die Fig. 4 ist bereits eingangs erläutert worden. In den Fig. 1 bis 3 werden für einander entsprechende Teile die gleichen Bezugszeichen wie in Fig. 4 verwendet. Auch können, wie in Fig. 4, die jeweils angegebenen Leitungstypen umgekehrt werden.

Fig. 1 zeigt ein Ausführungsbeispiel des erfindungsgemäßen MOSFETs. Im Unterschied zu dem herkömmlichen MOSFET nach Fig. 4 sind hier keine p-leitende Zonen 4, die von einer Isolierschicht 5 umgeben sind, vorgesehen. Vielmehr sind bei dem MOSFET des Ausführungsbeispiels von Fig. 1 Hilfselektroden 11 vorgesehen, die jeweils aus p⁺-dotiertem polykristallinem Silizium 12 bestehen und mit der Isolierschicht 5 umgeben sind. Auch kann die Isolierschicht 5 aus anderen Materialien als Siliziumdioxid, beispielsweise aus Siliziumnitrid oder aber auch aus verschiedenen Isolierfilmen, wie beispielsweise Siliziumdioxid oder Siliziumnitrid, bestehen.

Diese Hilfselektroden haben einen ähnlichen Effekt wie die p-leitenden Zonen 4 bei dem herkömmlichen MOSFET von Fig. 4: bei angelegter Drainspannung +U_{D} an den Drainanschluß D werden die n-leitenden Zonen 3 von. Ladungsträgern ausgeräumt. Auf der Isolierschicht 5 tritt dabei eine größere Feldstärke des elektrischen Feldes als bei dem MOSFET mit der herkömmlichen Struktur von Fig. 4 auf. Dies hat aber keine Auswirkung auf die angestrebte Ausräumung an Ladungsträgern.

Für die Herstellung des MOSFETs nach Fig. 4 brauchen lediglich Trenche 13 in den Halbleiterkörper 1 etwa bis zu der Schicht 2 mit einer Breite von etwa 1 bis 5 µm und einer Tiefe von etwa 5 bis 40 µm geätzt zu werden, deren Wände sodann durch Oxidation mit der Isolierschicht 5 aus Siliziumdioxid und einer Schichtdicke von 0,1 bis 1 µm belegt werden. Die Dicke der Isolierschicht 5 spielt dabei keine besondere Rolle: diese kann vielmehr in den Trenchen 13 von oben nach unten oder auch zur Mitte hin ansteigen.

Anschließend werden die Trenche mit dem polykristallinen Silizium 12 gefüllt das p⁺- dotiert ist. Eine p⁺-Dotierung für die Hilfselektroden 11 ist vorzusehen, da sie im Hinblick auf möglicherweise in der Isolierschicht 5 vorhandene Löcher eine größere Ausbeute ergibt, wie dies bereits oben erläutert wurde.

Die Hilfselektroden 11 können säulen-, gitter- oder streifenförmig oder in sonstiger Gestaltung vorgesehen werden.

Die n-leitenden Zonen 3 werden in bevorzugter Weise um so höher dotiert, je enger die Hilfselektroden 11 zueinander sind. Wesentlich ist lediglich, daß bei parallel zueinander verlaufenden Hilfselektroden 11 die seitliche Flächenladung der n-leitenden Zonen 3 das Doppelte der der Durchbruchsladung entsprechenden Dotierstoffmenge nicht überschreitet.

Anstelle der n-leitenden Zonen 3 (bzw. des Halbleiterkörpers 1) können auch mehrere Schichten mit unterschiedlicher Dotierung vorgesehen werden. Weiterhin kann die n⁺-leitende Zone 2 auch durch eine n-p⁺-Schichtfolge oder eine n⁺-p⁺-Schichtenfolge ersetzt werden, wie dies in Fig. 1 durch eine Strichlinie 15 angedeutet ist. In diesem Fall liegt dann ein IGBT vor (IGBT = Bipolartransistor mit isoliertem Gate).

Schließlich braucht die Dotierung des polykristallinen Siliziums 12 der Hilfselektroden 11 nicht homogen zu sein.

Fig. 2 zeigt ein weiteres Ausführungsbeispiel der Erfindung, bei dem im Unterschied zum Ausführungsbeispiel von Fig. 1 zwei Hilfselektroden 11 jeder Zelle zugeordnet sind. Selbstverständlich ist es auch möglich, gegebenenfalls drei oder mehr Hilfselektroden 11 für jede Zelle vorzusehen.

Schließlich ist es auch nicht erforderlich, daß die Hilfselektroden 11 bis zu der hochdotierten n⁺-leitenden Schicht 2 auf der Seite des Drainanschlusses D reicht. In gleicher Weise ist es möglich, daß diese Hilfselektroden 11 bereits an einer n⁻-leitenden Schicht 14 enden, die zwischen der n⁺-leitenden Schicht 2 und den n-leitenden Zonen 3 vorgesehen ist.

Die Erfindung ermöglicht so einen Kurzschlusssicheren MOSFET, der lediglich in der Halbleitertechnologie bei der Einbringung von Trenches übliche Schritte erfordert und einen niedrigen Einschaltwiderstand Rₒₙ gewährleistet.

## Patentansprüche

1. MOS-Feldeffekttransistor mit
- einem eine erste und eine zweite Hauptoberfläche aufweisenden Halbleiterkörper (1) des einen Leitungstyps, in den auf der Seite der ersten Hauptoberfläche wenigstens eine erste Halbleiterzone (6) des anderen, zum einen Leitungstyp entgegengesetzten Leitungstyps eingebettet ist,
- mindestens einer zweiten Halbleiterzone (7) des einen Leitungstyps, die in der ersten Halbleiterzone (6) vorgesehen ist,
- einer Gateelektrode (9) wenigstens im Bereich oberhalb der ersten Halbleiterzone (6) zwischen der zweiten Halbleiterzone (7) und dem Halbleiterkörper (1),
- einer den Halbleiterkörper (1) auf der zweiten Hauptoberfläche kontaktierenden ersten Elektrode (D) und einer mindestens die zweite Halbleiterzone (7) kontaktierenden zweiten Elektrode (10; S) und
- wenigstens einer mit einer Isolierschicht (5) versehenen Hilfselektrode (12), die sich im Halbleiterkörper (1) in der Richtung zwischen der ersten und der zweiten Hauptoberfläche des Halbleiterkörpers (1) erstreckt, wobei
- die Hilfselektrode (12) an die erste Halbleiterzone (6) angrenzt und
- die Isolierschicht (5) die Hilfselektrode (12) vom Halbleiterkörper (1) trennt,
**dadurch gekennzeichnet, dass** die Hilfselektrode (12) aus hochdotiertem polykristallinem Silizium des anderen Leitungstyps besteht, das mit der aus Siliziumdioxid bestehenden Isolierschicht (5) umgeben ist.

2. MOS-Feldeffekttransistor nach Anspruch 1,
**dadurch gekennzeichnet,**
**dass** direkt unterhalb jeder ersten Halbleiterzone (6) eine oder mehrere Hilfselektroden (12) vorgesehen sind.

3. MOS-Feldeffekttransistor nach Anspruch 1 oder 2,
**dadurch gekennzeichnet,**
**dass** die Hilfselektroden (12) bleistiftartig gestaltet sind.

4. MOS-Feldeffekttransistor nach einem der Ansprüche 1 bis 3,
**dadurch gekennzeichnet,**
**dass** die Hilfselektroden (12) bis zu einer stark dotierten Schicht (2) des einen Leitungstyps im Bereich der zweiten Hauptoberfläche reichen.

5. MOS-Feldeffekttransistor nach einem der Ansprüche 1 bis 3,
**dadurch gekennzeichnet,**
**dass** der Halbleiterkörper (1) eine schwach dotierte Halbleiterschicht (14) des einen Leitungstyps und eine mit der ersten Elektrode (D) kontaktierte stark dotierte Halbleiterschicht (2) des einen Leitungstyps aufweist.

6. MOS-Feldeffekttransistor nach einem der Ansprüche 1 bis 5,
**dadurch gekennzeichnet,**
**dass** die Tiefe der Hilfselektroden (12) 5 bis 40 µm beträgt.

7. MOS-Feldeffekttransistor nach einem der Ansprüche 1 bis 6,
**dadurch gekennzeichnet,**
**dass** die Breite der Hilfselektroden (12) etwa 1 bis 5 µm beträgt.

8. MOS-Feldeffekttransistor nach einem der Ansprüche 1 bis 7,
**dadurch gekennzeichnet,**
**dass** die Dicke der Isolierschicht (5) zwischen 0,1 µm und 1 µm liegt.

9. MOS-Feldeffekttransistor nach einem der Ansprüche 1 bis 8,
**dadurch gekennzeichnet,**
**dass** die Dicke der Isolierschicht (5) in Richtung auf die zweite Hauptoberfläche zu ansteigt.

10. MOS-Feldeffekttransistor nach einem der Ansprüche 1 bis 8,
**dadurch gekennzeichnet,**
**dass** die Dicke der Isolierschicht (5) zur Mitte der Hilfselektroden (12) hin ansteigt.

11. MOS-Feldeffekttransistor nach einem der Ansprüche 1 bis 10,
**dadurch gekennzeichnet,**
**dass** die Hilfselektroden (12) in Gräben (13) vorgesehen sind, die mit der Isolierschicht (5) und polykristallinem Silizium (12) aufgefüllt sind.

12. MOS-Feldeffekttransistor nach einem der Anspruchs 1 bis 11,
**dadurch gekennzeichnet,**
**dass** das polykristalline Silizium nicht homogen dotiert ist.

13. MOS-Feldeffekttransistor nach einem der Ansprüche 1 bis 12,
**dadurch gekennzeichnet,**
**dass** auf dem Halbleiterkörper (1) im Bereich der zweiten Hauptoberfläche eine hochdotierte Schicht (2) des einen Leitungstyps oder eine Schichtenfolge aus einer Schicht des einen Leitungstyps und einer hochdotierten Schicht des anderen Leitungstyps oder eine Schichtenfolge aus einer hochdotierten Schicht des einen Leitungstyps und einer hochdotierten Schicht des anderen Leitungstyps vorgesehen ist.

## Claims

1. MOS field-effect transistor having
- a semiconductor body (1) of one conduction type having a first and a second main surface, at least one first semiconductor zone (6) of the other conduction type, opposite to the first conduction type, being embedded in said semiconductor body on the side of the first main surface,
- at least one second semiconductor zone (7) of said one conduction type, which is provided in the first semiconductor zone (6),
- a gate electrode (9) at least in the region above the first semiconductor zone (6) between the second semiconductor zone (7) and the semiconductor body (1),
- a first electrode (D) which makes contact with the semiconductor body (1) on the second main surface, and a second electrode (10; S) which makes contact with at least the second semiconductor zone (7), and
- at least one auxiliary electrode (12) provided with an insulating layer (5), which auxiliary electrode extends, in the semiconductor body (1), in the direction between the first and the second main surface of the semiconductor body (1),
- the auxiliary electrode (12) adjoining the first semiconductor zone (6), and
- the insulating layer (5) isolating the auxiliary electrode (12) from the semiconductor body (1),
**characterized in that** the auxiliary electrode (12) is composed of highly doped polycrystalline silicon of the other conduction type, surrounded by the insulating layer (5) made of silicon dioxide.

2. MOS field-effect transistor according to claim 1,
**characterized**
**in that** one or more auxiliary electrodes (12) are provided directly underneath each first semiconductor zone (6).

3. MOS field-effect transistor according to claim 1 or 2,
**characterized in that** the auxiliary electrodes (12) are configured in a pencil-like manner.

4. MOS field-effect transistor according to one of claims 1 to 3,
**characterized in that** the auxiliary electrodes (12) reach as far as a heavily doped layer (2) of said one conduction type in the region of the second main surface.

5. MOS field-effect transistor according to one of claims 1 to 3,
**characterized**
**in that** the semiconductor body (1) has a weakly doped semiconductor layer (14) of said one conduction type, and a heavily doped semiconductor layer (2) of said one conduction type, the first electrode (D) making contact with said semiconductor layer.

6. MOS field-effect transistor according to one of claims 1 to 5,
**characterized**
**in that** the depth of the auxiliary electrodes (12) is from 5 to 40 µm.

7. MOS field-effect transistor according to one of claims 1 to 6,
**characterized**
**in that** the width of the auxiliary electrodes (12) is about 1 to 5 µm.

8. MOS field-effect transistor according to one of claims 1 to 7,
**characterized**
**in that** the thickness of the insulating layer (5) is between 0.1 and 1 µm.

9. MOS field-effect transistor according to one of claims 1 to 8,
**characterized**
**in that** the thickness of the insulating layer (5) increases in the direction toward the second main surface.

10. MOS field-effect transistor according to one of claims 1 to 8,
**characterized**
**in that** the thickness of the insulating layer (5) increases toward the center of the auxiliary electrodes (12).

11. MOS field-effect transistor according to one of claims 1 to 10,
**characterized**
**in that** the auxiliary electrodes (12) are provided in trenches (13) which are filled with the insulating layer (5) and polycrystalline silicon (12).

12. MOS field-effect transistor according to one of Claims 1 to 11,
**characterized**
**in that** the polycrystalline silicon is not homogeneously doped.

13. MOS field-effect transistor according to one of Claims 1 to 12,
**characterized**
**in that** a highly doped layer (2) of one conduction type or a layer sequence comprising a layer of one conduction type and a highly doped layer of the other conduction type or a layer sequence comprising a highly doped layer of one conduction type and a highly doped layer of the other conduction type is provided on the semiconductor body (1) in the region of the second main surface.

## Revendications

1. Transistor à effet de champ MOS, comprenant
- un corps (1) semi-conducteur, d'un type de conductivité, ayant une première et une deuxième surface principale et dans lequel est incorporé, du côté de la première surface principale, au moins une première zone (6) semi-conductrice de l'autre type de conductivité opposé au un type de conductivité,
- au moins une deuxième zone (7) semi-conductrice du un type de conductivité, qui est prévue dans la première zone (6) semi-conductrice,
- une électrode (9) de grille au moins dans la partie au-dessus de la première zone (6) semi-conductrice entre la deuxième zone (7) semi-conductrice et le corps (1) semi-conducteur,
- une première électrode (D) contactant le corps (1) semi-conducteur sur la deuxième surface principale et deuxième électrode (10 ; S) contactant au moins la deuxième zone (7) semi-conductrice, et
- au moins une électrode (12) auxiliaire munie d'une couche (5) isolante, qui s'étend dans le corps (1) semi-conducteur dans la direction entre la première et la deuxième surface principale du corps (1) semi-conducteur, dans lequel,
- l'électrode (12) auxiliaire est voisine de la première zone (6) semi-conductrice, et
- la couche (5) isolante sépare l'électrode (12) auxiliaire du corps (1) semi-conducteur,
**caractérisé**
**en ce que** l'électrode (12) auxiliaire est en silicium polycristallin très dopé de l'autre type de conductivité, qui est entouré de la couche (5) isolante en dioxyde de silicium.

2. Transistor à effet de champ MOS selon la revendication 1,
**caractérisé,**
**en ce qu'**une ou plusieurs électrodes (12) auxiliaires sont prévues directement en dessous de chaque première zone (6).

3. Transistor à effet de champ MOS, selon la revendication 1 ou 2,
**caractérisé,**
**en ce que** les électrodes (12) auxiliaires sont conformées à la façon d'un crayon.

4. Transistor à effet de champ MOS, selon l'une des revendications 1 à 3,
**caractérisé,**
**en ce que** ces électrodes (12) auxiliaires vont jusqu'à une couche (2) très dopée du un type de conductivité dans la partie de la deuxième surface principale.

5. Transistor à effet de champ MOS, suivant l'une des revendications 1 à 3,
**caractérisé,**
**en ce que** le corps (1) semi-conducteur a une couche (14) semi-conductrice faiblement dopée du un type de conductivité et une couche (2) semi-conductrice très dopée du un type de conductivité en contact avec la première électrode (D).

6. Transistor à effet de champ MOS, suivant l'une des revendications 1 à 5,
**caractérisé,**
**en ce que** la profondeur des électrodes (12) auxiliaires est comprise entre 5 et 40 µm.

7. Transistor à effet de champ MOS, selon l'une des revendications 1 à 6,
**caractérisé,**
**en ce que** la largeur des électrodes (12) auxiliaires est comprise entre environ 1 et 5 µm.

8. Transistor à effet de champ MOS, selon l'une des revendications 1 à 7,
**caractérisé,**
**en ce que** l'épaisseur de la couche (5) isolante est comprise entre 0,1 µm et 1 µm.

9. Transistor à effet de champ MOS, selon l'une des revendications 1 à 8,
**caractérisé,**
**en ce que** l'épaisseur de la couche (5) isolante augmente en direction de la deuxième surface principale.

10. Transistor à effet de champ MOS, selon l'une des revendications 1 à 8,
**caractérisé,**
**en ce que** l'épaisseur de la couche (5) isolante augmente en direction du milieu des électrodes (12) auxiliaires.

11. Transistor à effet de champ MOS, selon l'une des revendications 1 à 10,
**caractérisé,**
**en ce que** les électrodes (12) auxiliaires sont prévues dans des sillons (13) qui sont remplis de la couche (5) isolante et de silicium (12) polycristallin.

12. Transistor à effet de champ MOS, selon l'une des revendications 1 à 11,
**caractérisé,**
**en ce que** le silicium polycristallin est dopé d'une façon qui n'est pas homogène.

13. Transistor à effet de champ MOS, selon l'une des revendications 1 à 12,
**caractérisé,**
**en ce que** sur le corps (1) semi-conducteur dans la partie de la deuxième surface principale est prévue une couche (2) très dopée du un type de conductivité ou une succession de couche, composée d'une couche (2) du un type de conductivité et d'une couche très dopée de l'autre type de conductivité ou d'une succession de couche, composée d'une couche très dopée du un type de conductivité et d'une couche très dopée de l'autre type de conductivité.
